# EUROPÄISCHE PATENTSCHRIFT

(11) **EP 0 442 386 B1**
(45) Veröffentlichungstag und Bekanntmachung des Hinweises auf die Patenterteilung: **01.05.1996**
(21) Anmeldenummer: 91101749.9
(22) Anmeldetag: 08.02.1991
(51) Int. Cl.: G03F 7/023, G03F 7/039

(54) **Strahlungsempfindliches Gemisch, hiermit hergestelltes strahlungsempfindliches Aufzeichnungsmaterial und Verfahren zur Herstellung von Reliefaufzeichnungen**
Radiation-sensitive composition, radiation-sensitive recording material produced therewith and process for the production of relief records
Composition radiosensible, matériau d'enregistrement radiosensible produit avec celle-ci et procédé de la production d'enregistrements en relief

(30) Priorität: 15.02.1990 DE 4004719
(43) Veröffentlichungstag der Anmeldung: 21.08.1991
(73) Patentinhaber: HOECHST AKTIENGESELLSCHAFT, D-65926 Frankfurt am Main (DE)
(72) Erfinder: Elsässer, Andreas, Dr. Dipl.-Chem., W-6270 Idstein (DE); Frass, Hans Werner, Dr. Dipl.-Chem., W-6200 Wiesbaden (DE); Gaschler, Otfried, Dipl.-Ing., W-6200 Wiesbaden (DE); Mohr, Dieter, Dr. Dipl.-Chem., W-6501 Budenheim (DE); Buhr, Gerhard, Dr. Dipl.-Chem., W-6240 Königstein (DE)

(56) Entgegenhaltungen:
- EP-A- 0 327 991
- EP-A- 0 378 067

## Beschreibung

Strahlungsempfindliches Gemisch, hiermit hergestelltes strahlungsempfindliches Aufzeichnungsmaterial und Verfahren zur Herstellung von Reliefaufzeichnungen

Die Erfindung betrifft ein strahlungsempfindliches Gemisch, ein daraus hergestelltes Aufzeichnungsmaterial sowie ein Verfahren zur Herstellung von Reliefaufzeichnungen. Die Erfindung geht aus von einem normalerweise positiv, je nach Verarbeitungsweise, aber auch negativ arbeitenden, strahlungsempfindlichen Gemisch, das als wesentliche Bestandteile ein in Wasser unlösliches, in wäßrig-alkalischen Lösungen lösliches polymeres Bindemittel und ein 1,2-Chinondiazid enthält.

Diese strahlungsempfindlichen Gemische arbeiten dann positiv, wenn man ihre Löslichkeit in einer Entwicklerlösung durch Bestrahlung erhöht. Durch bekannte Verfahrensvariation ergeben die Gemische in Umkehrung auch negative Abbilder der Vorlagen. Diese Verarbeitungsweise erfordert nach der bildmäßigen Bestrahlung eine thermische Behandlung, bei der man das Material in einer dafür geeigneten Vorrichtung für eine bestimmte Zeit auf eine bestimmte Temperatur bringt. Hierdurch erfolgt die Konvertierung des Gemisches in den bestrahlten Bereichen von einem entwicklerlöslichen in einen in der Regel nicht mehr strahlungsempfindlichen, entwicklerunlöslichen Zustand.

Im einzelnen sind für die Negativ-Verarbeitung folgende Schritte erforderlich: bildmäßige Bestrahlung der das Gemisch enthaltenden Kopierschicht, thermische Behandlung, ganzflächige Bestrahlung und sich anschließende Entwicklung. Eine Variation dieses Verfahrens (US-A 4,544,627) kann darin bestehen, daß die bildmäßige Differenzierung im thermischen Schritt erfolgt, wobei man wie folgt vorgeht: ganzflächige Bestrahlung der das Gemisch enthaltenden Kopierschicht, bildmäßige Erhitzung z.B. mittels IR-Laserstrahlen und Entwicklung.

Es ist zwar grundsätzlich möglich, dieses im allgemeinen unter dem Begriff Bildumkehr zusammengefaßte Verfahren durchzuführen, ohne daß spezielle Gemischzusätze erforderlich sind (EP-A 131 238 entsprechned US-A 4 576 901) jedoch werden in der Regel Substanzen zugesetzt, die zweierlei bewirken sollen: zum einen soll der Bildumkehrspielraum erweitert werden und zum anderen soll der Angriff der Entwicklerlösung auf die Entwickler unlöslich gemachten Bereiche nach der Konvertierung verringert werden.

Unter Bildumkehrspielraum ist die Breite des Temperaturbereichs zu verstehen, innerhalb dessen die Konversion durchgeführt werden kann bzw. die Toleranzbreite der für die Konversion erforderlichen Zeit.

Die verwendbaren Gemischzusätze lassen sich in zwei Klassen einteilen: zum einen in Additive, die in Gegenwart der bei der Bestrahlung gebildeten Inden-Carbonsäure thermisch eine Vernetzungsreaktion im lichtempfindlichen Gemisch bewirken und zum zweiten in Zusätze, die die zur Decarboxylierung der bei der Bestrahlung gebildeten Säure erforderliche Energie herabsetzen (S.A.MacDonald et al.: "Image Reversal. The Production of a Negative Image in a Positive Photoresist", Interface 82, San Diego 1982).

Zur ersten Klasse sind die folgenden Zusätze zu rechnen: Resole (GB-A 2 082 339), Alkoxymethyl- oder Glycidyl-substituierte Aromaten (EP-A 0 212 482), monomere oder oligomere Melamin- bzw. Harnstoff-Formaldehyd-Kondensate (EP-A 0 133 216, DE-A 3 711 264); zur zweiten Klasse rechnet man:: sekundäre oder tertiäre Amine mit einem Siedepunkt größer als 200 °C (US-A 4 196 003), Ammonium-(EP-A 0 141 400 entsprechend US-A 4 696 891) bzw. Phosphoniumsalze (DE-A 3 437 687), Monazolin (DE-A 25 29 054 entsprechend US-A 4 104 070) bzw. N-substituierte Ethylendiamine (DE-A 28 55 723), Amino-alkoxy-s-triazine (DE-A 37 11 263), Tris-phenoxy-s-triazine (DE-A 37 25 949) oder Chinone bzw. aromatische Ketone (US-A 4 356 255).

Eine dritte Verfahrensvariante besteht darin, daß der Zusatz zur Verbreiterung des Bildumkehrspielraums nicht von vorneherein in der strahlungsempfindlichen Schicht zugegen ist, sondern zwischen bildmäßiger Bestrahlung und thermischer Behandlung angetragen wird, wie dies etwa in DE-A 35 41 451 und US-A 4 775 609 beschrieben ist, wobei das Material einer Ammoniak-Atmosphäre ausgesetzt wird.

Auf Grund der Tatsache, daß die Gemischzusätze der ersten Klasse, die an einer säurekatalysierten Vernetzungsreaktion beteiligt sind, generell die Lagerstabilität des Gemisches stärker beeinträchtigen als die der zweiten Klasse, sind letztere die bevorzugten Zusätze.

Die technisch erfoderliche Breite des Verarbeitungsspielraums für die Bildumkehr wird mit Zusätzen der zweiten Klasse, wie z.B. den in DE-A 37 11 263 beschriebenen Amino-alkoxy-s-triazinen, erzielt. Unbefriedigend ist jedoch, daß der Angriff der Entwicklerlösung gegen die konvertierten Bildbereiche noch relativ hoch ist. Dies kann dazu führen, daß es bei der Entwicklung des latenten Negativbildes zu einem unter Umständen beträchtlichen Abtrag des Kopierlacks in diesen Bereichen kommt. Hieraus resultiert, daß die mit einer so gefertigten Druckform erzielbare Druckauflage geringer ausfällt und daß es durch die hohe Belastung des Entwicklers mit konvertiertem Kopiermaterial, dessen Löslichkeit im Entwickler wiederum begrenzt ist, zu einer frühzeitigen und unerwünschten Erschöpfung des Entwicklers kommt.

Aufgabe der Erfindung war es daher, ein strahlungsempfindliches Gemisch bereitzustellen, das eine gute Lagerstabilität besitzt, einen breiten Bildumkehrspielraum aufweist und das nach Konvertierung weniger vom Entwickler angegriffen wird als die bekannten Gemische.

Die Erfindung geht aus von einem strahlungsempfindlichen Gemisch, das als wesentliche Bestandteile ein in Wasser unlösliches, in wäßrig-alkalischen Lösungen lösliches Bindemittel, ein 1,2-Chinondiazid und eine, die Entwicklerlöslichkeit der belichteten Bereiche durch thermische Behandlung vermindernde Verbindung enthält. Das Gemisch ist dadurch gekennzeichnet, daß es als die Entwicklerlöslichkeit vermindernde Verbindung mindestens ein Urethan der allgemeinen Formel I enthält: 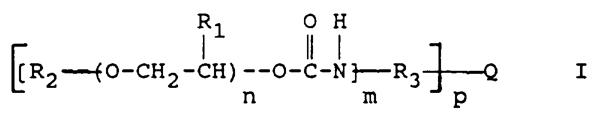 worin
- R₁: Wasserstoff oder Methyl,
- R₂: Wasserstoff, Alkyl, gegebenenfalls substituiertes Aryl oder ein gegebenenfalls substituiertes Arylaminocarbonyl,
- R₃: ein gegebenenfalls substituiertes Arylen oder Arylen-Alkylen,
- Q: Wasserstoff, -CH₄₋ₚ, CR₅R₆ mit R₅ und R₆, die gleich oder verschieden sein können und Wasserstoff, Alkyl oder Aryl bedeuten,
Carbonyl, ein Sauerstoff- oder Schwefelatom oder Sulfonyl,
- m: 1, 2 oder 3 und
- n: eine Zahl ≥ 1 und ≤ 50 und
- p: 1, 2 oder 3
bedeuten.

Bevorzugt sind Verbindungen der allgemeinen Formel I worin:
- R₁: Wasserstoff oder Methyl
- R₂: Wasserstoff, C₁-C₂-Alkyl,Phenyl, Naphthyl, oder Phenylaminocarbonyl, die durch Alkyl substituiert sein können,
- R₃: Phenylen, das Alkyl substituiert sein kann,
- Q: Wasserstoff oder Methylen,
- m: 1 oder 2,
- n: eine Zahl ≥ 3 und ≤ 25 und
- p: 1 oder 2
bedeuten.

Insbesondere sind Verbindungen der allgemeinen Formel I bevorzugt, in denen
- R₁: Wasserstoff,
- R₂: Phenyl, Phenylaminocarbonyl, die durch Alkyl substituiert sein können,
- R₃: Phenylen,
- Q: Wasserstoff
- m: 1
- n: eine Zahl ≥ 3 und ≤ 25 und
- p: 1
bedeuten.

Die Herstellung der erfindungsgemäßen Urethanverbindungen erfolgt auf einfache Art und Weise durch Umsetzung der entsprechenden mono- oder bifunktionellen Alkohole mit mono-, bi- oder trifunktionellen Isocyanaten.

Beispiele für erfindungsgemäße Urethanverbindungen sind Umsetzungsprodukte aus monofunktionellen Alkoholen, wie Ethylenglykol-mono-methyl- oder -ethylether, Propylenglykol-mono-methyl- oder -ethylether, Di-, Tri- oder Tetraethylen- oder Propylenglykol-mono-methyl, -ethyl- oder -butylether, Fettalkoholoxethylate, wie Genapol^{R}-Typen der Hoechst AG, Alkylphenoloxethylate, wie Nonylphenoloxethylate (Arkopal^{R}-N, Hoechst AG), Tributylphenoloxethylate, wie Sapogenat^{R}-T, Hoechst AG), Monobutylether von Ethylenoxid/Propylenoxid-Copolymerisaten (Polyglykol^{R}-B-Typen, Hoechst AG) und/oder bifunktionellen Alkoholen, wie Mono-, Di-, Tri-, Tetra-, Pentaethylen- oder Propylenglykole, Ethylen/Propylenblockpolymerisate, wie Genapol^{R}-PF oder Pluriol^{R}-PE-Typen der Hoechst bzw. BASF AG mit monofunktionellen Isocyanaten, wie Phenyl-, 3 oder 4-Chlorphenyl-, 3,4-Dichlorphenyl-, 3-Trifluormethylphenyl-, 4-Methylphenyl-, 4-Isopropylphenyl-, 1-Naphthylisocyanat und/oder bifunktionellen Isocyanaten, wie 2,4- oder 2,6-Toluoldiisocyanat, 4,4'- oder 2,4'- oder 2,2'-Diphenylmethandiisocyanat, oder 1,5-Naphthyldiisocyanat und/oder trifunktionellen Isocyanaten, wie Triphenylmethantriisocyanat, dem Addukt aus Trimethylolpropan und Toluoldiisocyanat (Desmodur^{R}, Bayer AG).

Die Konzentration der erfindungsgemäßen Urethane in dem strahlungsempfindlichen Gemisch kann in relativ weiten Grenzen schwanken. Im allgemeinen liegt der Anteil bei 0,5 bis 30, vorzugsweise zwischen 1 und 25 Gewichtsprozenten, bezogen auf das Gewicht der nicht-flüchtigen Bestandteile des strahlungsempfindlichen Gemisches.

Die folgenden Erläuterungen beschreiben näher die Zusammensetzung der strahlungsempfindlichen Gemische und Schichten, die Art der Schichtträger sowie die weiteren Prozeßschritte in der Verarbeitung der Aufzeichnungsmaterialien.

Das erfindungsgemäße strahlungsempfindliche Gemisch enthält als 1,2-Chinondiazid bevorzugt ein 1,2-Naphthochinon-2-diazid-derivat, das in 4- oder 5-Position einen elektronegativen Substituenten, wie eine Aryloxysulfonylgruppe besitzt. Als 1,2-Chinondiazide werden insbesondere 1,2-Naphthochinon-diazid-(2)-4-sulfonsäureester oder - amide verwendet. Geeignete Verbindungen dieser Art sind bekannt und zum Beispiel in DE-C 938 233, entsprechend GB-B 739 654 und DE-A 25 47 905, entsprechned GB-B 1 561 438 beschrieben.

Die Menge von 1,2-Chinondiazidverbindungen beträgt im allgemeinen 3 bis 50, bevorzugt 7 bis 35 Gewichtsprozent, bezogen auf Gesamtfeststoff des Gemisches.

Als Bindemittel werden Polykondensate oder Polymerisate mit freien phenolischen Hydroxylgruppen eingesetzt, wobei der Gehalt an phenolischen Hydroxylgruppen bevorzugt im Bereich von 1 und 10 mmol/g Bindemittel liegt. Als Beispiele für Polykondensate sind zu nennen, Phenolharze vom Novolaktyp oder hydroxy-substituierte Aramide. Als Beispiele für Polymerisate seien genannt: Homo- und Copolymerisate von Vinylphenolen (DE-A 23 22 230, entsprechend US-A 3 869 292 und DE-A 3 406 927, entsprechend US-A 4 678 737), Polymerisate der Ester von Acrylsäuren mit Phenolen (JP-A 76/36 129 und EP-A 0 212 439) oder Copolymerisate von Hyroxyphenylmaleinimiden (EP-A 0 187 517). Die Glasübergangstemperaturen dieser Bindemittel variieren je nach Anwendungsbereich. Für Trockenresistanwendungen, wo eine gute Laminierbarkeit gefordert ist, sind Glasübergangstemperaturen ≤ 100 °C vorteilhaft. Im Falle der Anwendung im Flachdruck oder in der Fertigung mikroelektronischer Schaltungen sind Glasübergangstemperaturen ≥ 100 °C günstig. Die Menge des Bindemittels beträgt im allgemeinen 20 bis 90, vorzugsweise 50 bis 85 Gewichtsprozent der nichtflüchtigen Bestandteile des Gemisches.

Zusätzlich können noch zahlreiche andere Oligomere und Polymere mitverwendet werden, z.B. Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 20 Gewichtsprozent vom Bindemittel mit seitenständigen phenolischen Gruppen. In geringen Mengen kann die lichtempfindliche Schicht für spezielle Erfordernisse wie Flexibilität, Haftung, Glanz etc. außerdem noch Substanzen wie Polyglykole, Celluloseether, z.B. Ethylcellulose, Netzmittel und feinteilige Pigmente enthalten.

Ferner können dem lichtempfindlichen Gemisch noch lösliche oder auch feinteilige dispergierbare Farbstoffe sowie, je nach Anwendungszweck, auch UV-Absorber zugesetzt werden.

Je nach Art des Farbstoffs, der dem Gemisch zugesetzt wird, um unmittelbar nach Belichtung ein sichtbares Abbild der Vorlage auf dem Aufzeichnungsmaterial anzuzeigen, kann es sinnvoll sein, photochemische Säurebildner zuzusetzen, um den Belichtungskontrast zu verstärken.

Als lichtempfindliche Komponenten, die beim Belichten starke Säure bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar (US-A 3 779 778). Von diesen Verbindungen werden die s-Triazinderivate mit Halogenmethylgruppen, insbesondere Trichlormethylgruppen, und mit einem aromatischen bzw. ungesättigten Substituenten am Triazinkern, wie sie in DE-A 27 18 259, entsprechend US-A 4 189 323, beschrieben sind, bevorzugt. Ebenso geeignet sind 2-Trichlormethyl-1,3,4-oxdiazole (DE-A 28 51 471, entsprechend US-A 4 212 970). Die Wirkung dieser halogenhaltigen Verbindungen kann auch durch bekannte Sensibilisatoren spektral beeinflußt und gesteigert werden.

Die Erfindung betrifft auch ein strahlungsempfindliches Aufzeichnungsmaterial aus einem Schichtträger und einer darauf aufgebrachten strahlungsempfindlichen Schicht, die ein erfindungsgemäßes strahlungsempfindliches Gemisch enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykol-monoethylether und Ester, wie Butylacetat. Es können auch Gemische verwendet werden, die zudem noch für spezielle Zwecke Lösungsmittel, wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorzirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle, z.B. einen Argon- oder Krypton-Ionen-Laser enthalten.

Die Bestrahlung kann ferner mit Elektronenstrahlen erfolgen. Auch Röntgenstrahlen können zur Bilderzeugung verwendet werden.

Die bildmäßig belichtete oder bestrahlte Schicht kann in bekannter Weise mit praktisch den gleichen Entwicklern, wie sie für handelsübliche Naphthochinondiazid-Schichten und Kopierlacke bekannt sind, entfernt werden, oder die erfindungsgemäßen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurzzeitig auf erhöhte Temperaturen erwärmt werden, wie es für Diazoschichten aus der GB-B 1 154 749 bekannt ist.

Wie schon eingangs erwähnt kann das erfindungsgemäße strahlungsempfindliche Aufzeichnungsmaterial normal als positiv arbeitendes Material verarbeitet werden. Es ist aber auch negativ arbeitend verarbeitbar sowie in Kombination beider Verfahrensarten (Photocomposing). Ganz besonders geeignet ist das erfindungsgemäße Material in einem Verfahren verarbeitbar zur Negativherstellung eines normalerweise positiv arbeitenden strahlungsempfindlichen Aufzeichnungsmaterials aus einem Schichtträger und einer darauf aufgebrachten strahlungsempfindlichen Schicht durch bildmäßiges Belichten, thermisches Behandeln, Ausbelichten der Schicht ohne Vorlage und anschließendes Entwickeln mit einem Entwickler, bei dem man ein erfindungsgemäßes strahlungsempfindliches Aufzeichnungsmaterial verwendet und bei dem man die thermische Behandlung bei Temperaturen zwischen 80 ° und 150 °C und innerhalb von 10 Sekunden und 5 Minuten durchführt.

Durch die Erfindung wird erreicht, daß ein strahlungsempfindliches Gemisch und Aufzeichnungsmaterial zur Verfügung gestellt werden kann, das eine gute Lagerstabilität bei guter Strahlungsempfindlichkeit besitzt, das einen technisch erwünschten breiten Bildumkehrspielraum aufweist und dessen Bildbereiche nach der Konvertierung weit weniger von dem Entwickler angegriffen werden als dies bei bekannten Materialien der Fall ist.

Im folgenden werden Beispiele der bevorzugten Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

### Beispiel 1

Es wird eine Beschichtungslösung hergestellt aus
- 8,0 Gt: eines m-Kresol-Formaldehyd-Novolaks mit einem Molgewichtsmittelwert von 6.000,
- 1,6 Gt: eines Veresterungsproduktes aus 1 Mol 1,2-Naphthochinon-(2)-diazid-4-sulfonylchlorid und 1 Mol p-Cumylphenol,
- 0,4 Gt: eines Zusatzes entsprechend Tabelle 1 und 2,
- 0,1 Gt: Kristallviolett, Color Index (C.I.) 42555,
- 0,02 Gt: Sudangelb GGN, C.I. 11021,
- 100 Gt: eines Lösungsmittelgemisches aus Tetrahydrofuran und Propylenglykolmonomethylether (55:45).

Diese Lösung wird auf eine in Salzsäure aufgerauhte, in Schwefelsäure anodisierte und mit Polyvinylphosphonsäure hydrophilierte Aluminiumfolie schleuderbeschichtet.

Nach 2 Minuten Trocknen bei 100 °C resultiert eine Schichtdicke von 2 µm.

Die Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 65 Sekunden lang belichtet, 2 Minuten bei 130 °C in einem Umluftofen konvertiert, 45 Sekunden lang ohne Vorlage ausbelichtet und dann in folgendem Entwickler 1 Minute entwickelt:
7,6 Gt K₂SiO₃
1,2 Gt K₃PO₄
91,3 Gt H₂O.

In Tabelle 2 ist die gefundene Halbtonkeilwiedergabe von der voll gedeckten Stufe bis zu der, die erstmals einen Schleier zeigt, angegeben. Weiterhin ist angegeben, welche offene Stufe erhalten wird, wenn nach der bildmäßigen Belichtung entwickelt wird, also eine Positivverarbeitung durchgeführt wird.

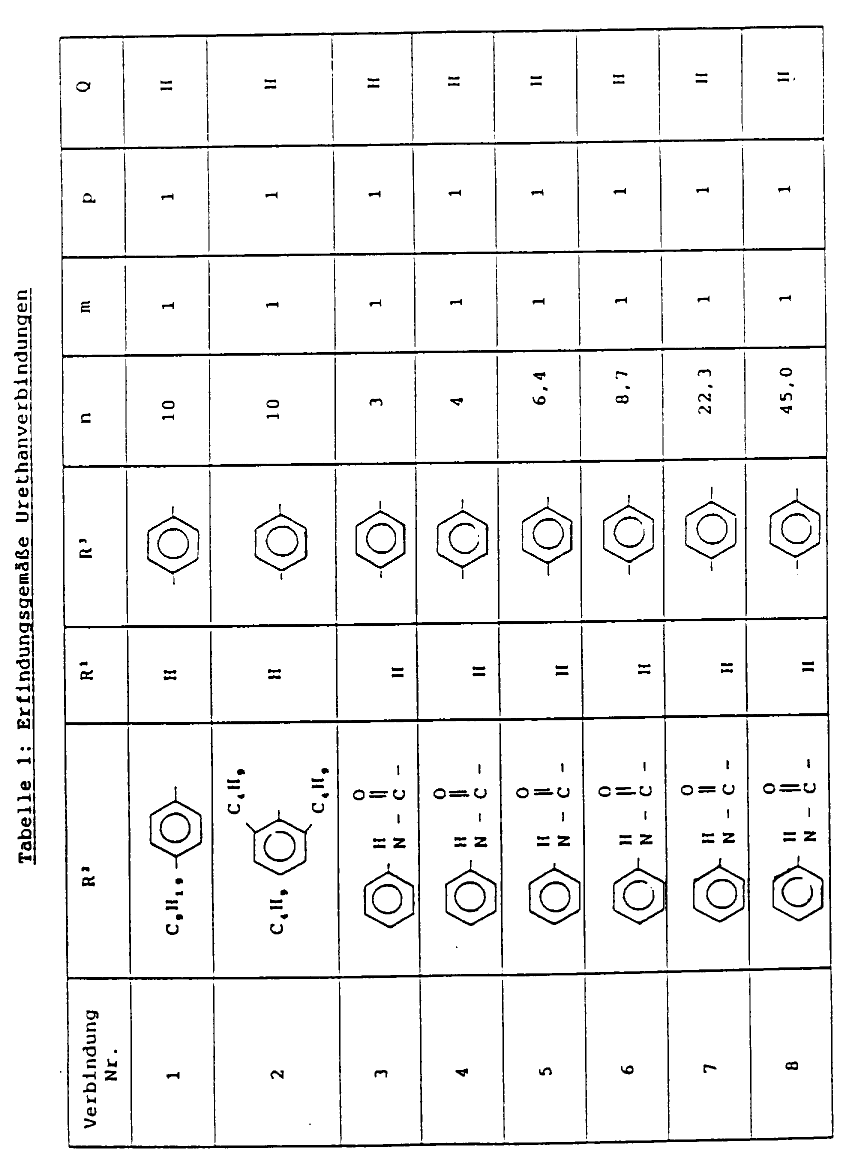

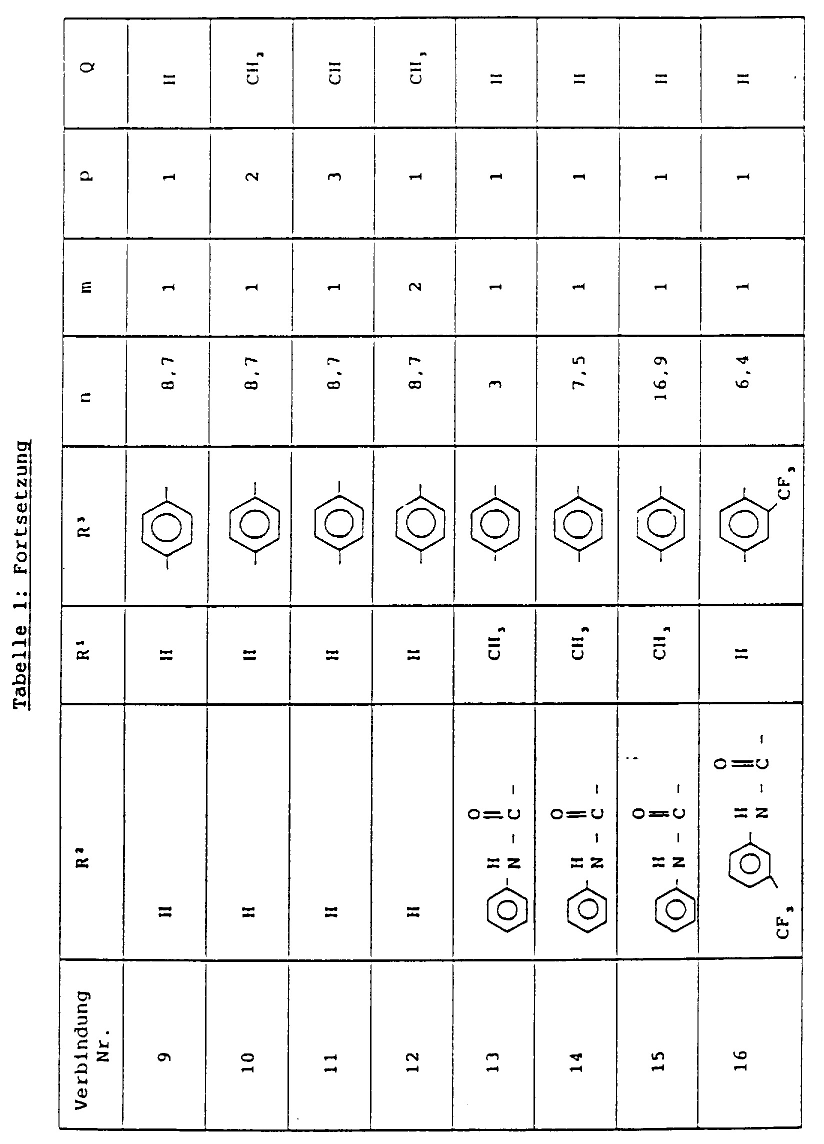

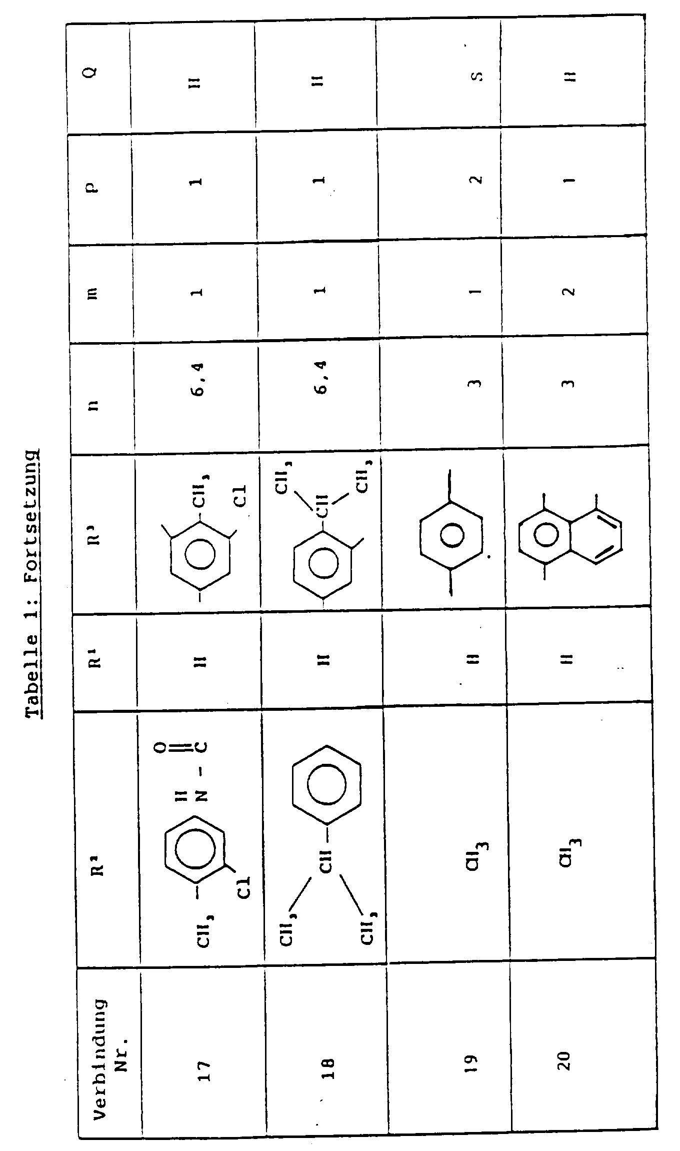

**Tabelle 2**

| Beispiel Nr. | Zusatz | Negativverarbeitung | Positivverarbeitung |
|---|---|---|---|
| 1-1 | 1 (Tabelle 1) | 2-5 | 2 |
| 1-2 | 2 | 2-5 | 2 |
| 1-3 | 3 | 2-5 | 2 |
| 1-4 | 4 | 2-5 | 2 |
| 1-5 | 5 | 2-5 | 2 |
| 1-6 | 6 | 2-5 | 2 |
| 1-7 | 7 | 2-5 | 2 |
| 1-8 | 8 | 2-5 | 2 |
| 1-9 | 9 | 2-5 | 2 |
| 1-10 | 10 | 2-5 | 2 |
| 1-11 | 11 | 2-5 | 2 |
| 1-12 | 12 | 2-5 | 2 |
| 1-13 | 13 | 2-5 | 2 |
| 1-14 | 14 | 2-5 | 2 |
| 1-15 | 15 | 2-5 | 2 |
| 1-16 | 16 | 2-5 | 2 |
| 1-17 | 17 | 2-5 | 2 |
| 1-18 | 18 | 2-5 | 2 |
| 1-19 | 19 | 2-5 | 2 |
| 1-20 | 20 | 2-5 | 2 |
| 1-21 | 2-Diethylamino-4,6-diethoxy-s-triazin gem. DE-A 37 11 263 | 2-5 | 2 |
| | | starker Schichtangriff | |
| 1-22 | Hexakis-methoxy-methylmelamin gem. EP-A 0 133 216 | 1-4 | |
| | | mittlerer-starker Schichtangriff | 2 |

Diese Ergebnisse zeigen, daß die Positivverarbeitung in allen Fällen ohne Probleme möglich ist, die Negativverarbeitung jedoch nur bei den erfindungsgemäßen Zusätzen ohne starke Schädigung der konvertierten Bildpartien möglich ist.

Von einigen dieser positiv bzw. negativ verarbeiteten Druckplatten wurde in einer Bogenoffsetdruckmaschine die Druckauflage bestimmt:

| Bsp.-Nr. | Druckauflage bei | |
|---|---|---|
| | Positivverarbeitung | Negativverarbeitung |
| 1-5 | 90.000 | 80.000 |
| 1-6 | 90.000 | 80.000 |
| 1-14 | 90.000 | 80.000 |
| 1-17 | 90.000 | 80.000 |
| 1-21 | | |
| (DE-A 37 11 263) | 90.000 | 50.000 |
| 1-22 | | |
| (EP-A 133 216) | 90.000 | 60.000 |

Diese Ergebnisse zeigen, daß bei den Druckplatten, die strahlungsempfindliche Schichten mit den erfindungsgemäßen Zusätzen besitzen, die bei Negativverarbeitung erzielbare Druckauflage nahezu der der Positivverarbeitung entspricht. Dagegen weisen die Vergleichsdruckplatten, deren Bildpartien bei Negativverarbeitung vom Entwickler angegriffen werden, bei Negativverarbeitung eine deutlich geringere Druckauflage als bei Positivverarbeitung auf.

Weiterhin wurde von einer Reihe der Platten der Verarbeitungsspielraum bei Negativverarbeitung bestimmt. Dies wurde in der Art und Weise durchgeführt, daß die Temperatur bei der Temperung bei Negativverarbeitung bei ansonsten gleicher Verarbeitungsweise wie oben beschrieben variiert wurde.

Die folgende Tabelle gibt die Ergebnisse wieder.

| Bsp.-Nr. | Temperaturspielraum [°C] bei Negativverarbeitung |
|---|---|
| 1-5 | 105 - 150 |
| 1-6 | 105 - 150 |
| 1-10 | 100 - 150 |
| 1-17 | 105 - 150 |
| 1-21 | 100 - 150 |
| (DE-A 37 11 263) | generell Schichtangriff |
| 1-22 | 130 - 150, |
| (EP-A 133 216) | generell Schichtangriff |

Die Ergebnisse zeigen, daß die erfindungsgemäßen Zusätze einen den Triazinderivaten (DE-A 37 11 263) vergleichbaren Verarbeitungsspielraum liefern, der den unter saurer Katalyse aushärtenden Zusätzen deutlich überlegen ist.

Zur Prüfung der Langzeithaltbarkeit wurden die Platten in einem Lacktrockenschrank bei 100 °C gelagert und in Intervallen von 0,5 Stunden Proben entnommen und wie oben beschrieben positiv verarbeitet. Als Lagerstabilität wird der Wert der Lagerzeit bezeichnet, bis zu dem eine einwandfreie Verarbeitung - d.h. unbeeinträchtigtes Entwicklungsverhalten - möglich war. Der Test wurde nach 3 Stunden abgebrochen.

| Bsp.-Nr. | Lagerstabilität [Stunden] |
|---|---|
| 1-5 | > 3 |
| 1-6 | > 3 |
| 1-10 | > 3 |
| 1-14 | > 3 |
| 1-17 | > 3 |
| 1-21 | > 3 |
| (DE-A 37 11 263) | |
| 1-22 | 2 |
| (EP-A 133 216) | |

Die Werte zeigen, daß die Lagerstabilität der mit den erfindungsgemäßen Zusätzen erhaltenen Schichten deutlich über der der säurekatalysiert aushärtenden Zusätze liegt und damit den praktischen Anforderungen genügt.

### Beispiel 2

Es wird eine Beschichtungslösung hergestellt aus
- 1,700 Gt: des Veresterungsproduktes aus 1 Mol 2,3,4-Trihydroxybenzophenon und 1 Mol 1,2-Naphthochinon-(2)-diazid-4-sulfonylchlorid,
- 0,600 Gt: des Zusatzes entsprechend Tabelle 3,
- 8,500 Gt: eines Kresol-Formaldehyd-Novolaks mit einem Erweichungspunkt von 127 - 145 °C,
- 0,060 Gt: 2,4-Bis-trichlormethyl-6-p-stilbenyl-s-triazin,
- 0,070 Gt: Kristallviolett, C.I. 42555, in
- 70,00 Gt: Propylenglykolmonomethylether und
- 70,00 Gt: Tetrahydrofuran

Die Lösungen werden auf eine wie in Bespiel 1 behandelte Aluminiumfolie durch Schleudern aufgebracht und getrocknet, so daß eine Schichtdicke von 2 µm resultiert.

Es werden die gleichen Prüfungen vorgenommen, wie in Beispiel 1 unter denselben Bedingungen und demselben Entwickler. Tabelle 3 gibt die Ergebnisse wieder.

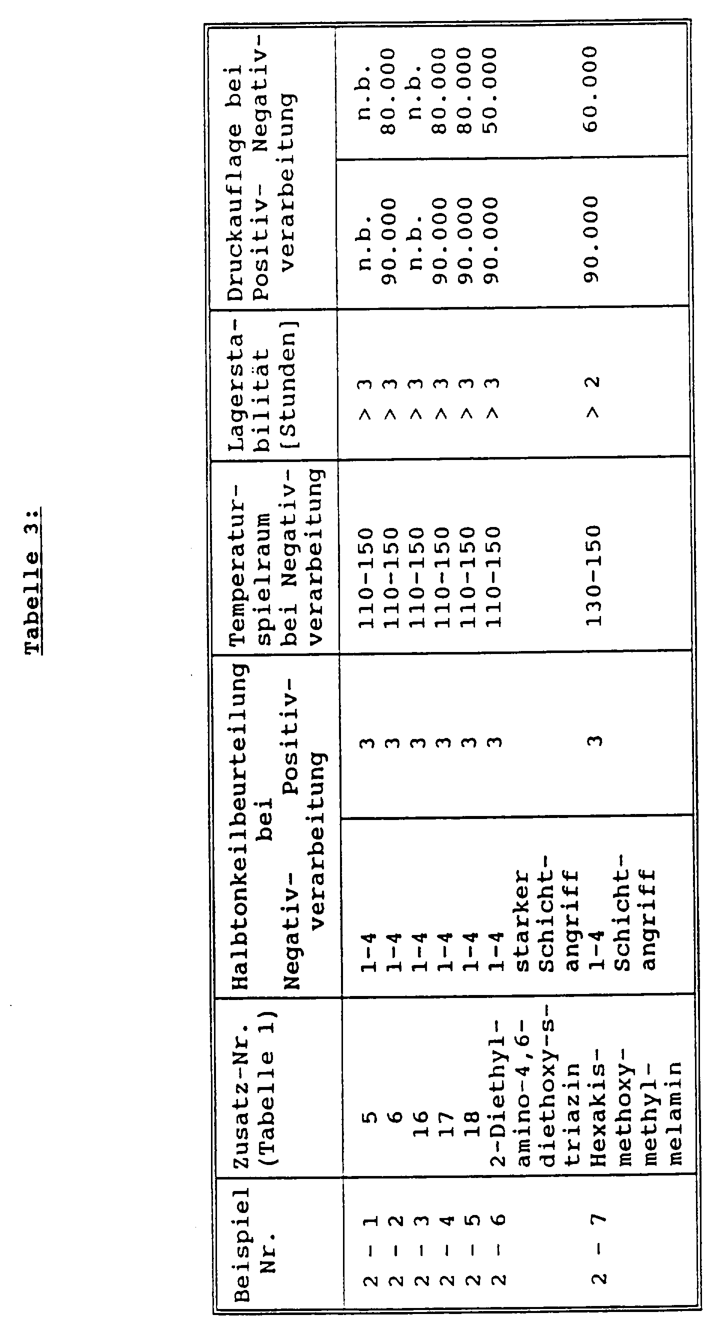

Die Resultate dieser Versuchsreihe zeigen ebenfalls deutlich, daß mit den erfindungsgemäßen Zusätzen beim Einsatz eines stark alkalischen Entwicklers das insgesamt beste Verhalten bei Negativverarbeitung gefunden wird.

## Patentansprüche

1. Strahlungsempfindliches Gemisch, das als wesentliche Bestandteile ein in Wasser unlösliches,in wäßrig-alkalischen Lösungen lösliches Bindemittel, ein 1,2-Chinondiazid und eine, die Entwicklerlöslichkeit der belichteten Bereiche durch thermische Behandlung vermindernde Verbindung enthält, dadurch gekennzeichnet, daß es als die Entwicklerlöslichkeit vermindernde Verbindung mindestens ein Urethan der allgemeinen Formel I enthält: 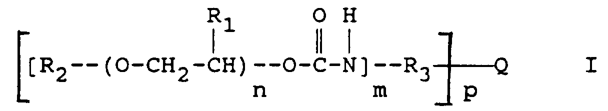 worin
R₁ Wasserstoff oder Methyl,
R₂ Wasserstoff, Alkyl, gegebenenfalls substituiertes Aryl oder ein gegebenenfalls substituiertes Arylaminocarbonyl,
R₃ ein gegebenenfalls substituiertes Arylen oder Arylen-Alkylen,
Q Wasserstoff, -CH₄₋ₚ, CR₅R₆ mit R₅ und R₆, die gleich oder verschieden sein können und Wasserstoff, Alkyl oder Aryl bedeuten,
Carbonyl, ein Sauerstoff- oder Schwefelatom oder Sulfonyl,
m 1, 2 oder 3 und
n eine Zahl ≥ 1 und ≤ 50 und
p 1, 2 oder 3
bedeuten.

2. Gemisch nach Anspruch 1, dadurch gekennzeichnet, daß es mindestens eine Verbindung entsprechend der allgemeinen Formel I enthält,
worin:
R₁ Wasserstoff oder Methyl,
R₂ Wasserstoff, C₁-C₂-Alkyl,Phenyl, Naphthyl oder Phenylaminocarbonyl, die durch Alkyl substituiert sein können,
R₃ Phenylen, das Alkyl substituiert sein kann,
Q Wasserstoff oder Methylen,
m 1 oder 2,
n eine Zahl ≥ 3 und ≤ 25 und
p 1 oder 2
bedeuten.

3. Gemisch nach Anspruch 1 oder 2, dadurch gekennzeichnet, daß es mindestens eine Verbindung entsprechend der allgemeinen Formel I enthält, worin:
R₁ Wasserstoff,
R₂ Phenyl, Phenylaminocarbonyl, die durch Alkyl substituiert sein können,
R₃ Phenylen,
Q Wasserstoff,
m 1,
n eine Zahl ≥ 3 und ≤ 25 und
p 1
bedeuten.

4. Strahlungsempfindliches Gemisch nach Anspruch 1 bis 3, dadurch gekennzeichnet, daß es 0,5 bis 30 Gewichtsprozent, bezogen auf das Gewicht der nichtflüchtigen Bestandteile des Gemisches, an Verbindungen nach der allgemeinen Formel I enthält.

5. Strahlungsempfindliches Gemisch nach Anspruch 1, dadurch gekennzeichnet, daß das 1,2-Chinondiazid ein 1,2-Naphthochinon-2-diazid-derivat ist, das in 4- oder 5-Position einen elektronegativen Substituenten besitzt.

6. Strahlungsempfindliches Gemisch nach Anspruch 5, dadurch gekennzeichnet, daß der elektronegative Substituent eine Aryloxysulfonylgruppe ist.

7. Strahlungsempfindliches Gemisch nach Anspruch 1, dadurch gekennzeichnet, daß das Bindemittel ein Polykondensat oder Polymerisat mit einem Gehalt an phenolischen Hydroxylgruppen im Bereich von 1 bis 10 mmol/g Bindemittel ist.

8. Strahlungsempfindliches Aufzeichnungsmaterial aus einem Schichtträger und einer darauf aufgebrachten strahlungsempfindlichen Schicht, die ein Gemisch nach Ansprüchen 1 bis 7 enthält.

9. Verfahren zur Negativherstellung eines normalerweise positiv arbeitenden strahlungsempfindlichen Aufzeichnungsmaterials aus einem Schichtträger und einer darauf aufgebrachten strahlungsempfindlichen Schicht durch bildmäßiges Belichten, thermisches Behandeln, Ausbelichten der Schicht ohne Vorlage und anschließendes Entwickeln mit einem Entwickler, dadurch gekennzeichnet, daß man ein strahlungsempfindliches Aufzeichnungsmaterial nach Anspruch 8 verwendet und bei dem man die thermische Behandlung bei Temperaturen zwischen 80 ° und 150 °C und innerhalb von 10 Sekunden und 5 Minuten durchführt.

## Claims

1. A radiation-sensitive mixture which contains as essential components a binder which is insoluble in water and soluble in aqueous-alkaline solutions, a 1,2-quinone diazide and a compound which diminishes the developer solubility of the exposed regions by heat treatment, which mixture contains as the compound which diminishes the developer solubility, at least one urethane of the formula I: 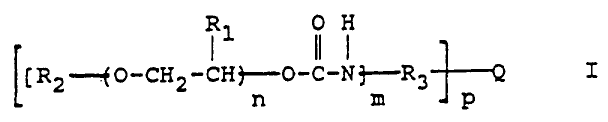 in which
R₁ is hydrogen or methyl,
R₂ is hydrogen, alkyl, substituted or unsubstituted aryl or substituted or unsubstituted arylaminocarbonyl,
R₃ is substituted or unsubstituted arylene or arylenealkylene,
Q is hydrogen, -CH₄₋ₚ, CR₅R₆ with R₅ and R₆, which can be identical or different, and hydrogen, alkyl or aryl,
carbonyl, an oxygen or sulfur atom or sulfonyl,
m is 1, 2 or 3 and
n is a number ≥ 1 and ≤ 50 and
p is 1, 2 or 3.

2. A mixture as claimed in claim 1, which contains at least one compound of the formula I, in which:
R₁ is hydrogen or methyl,
R₂ is hydrogen, C₁-C₂-alkyl, phenyl, naphthyl, or phenylaminocarbonyl, which can be substituted by alkyl,
R₃ is phenylene, which can be substituted by alkyl,
Q is hydrogen or methylene,
m is 1 or 2,
n is a number ≥ 3 and ≤ 25 and
p is 1 or 2.

3. A mixture as claimed in claim 1 or 2, which contains at least one compound of the formula I, in which:
R₁ is hydrogen,
R₂ is phenyl, phenylaminocarbonyl, which can be substituted by alkyl,
R₃ is phenylene,
Q is hydrogen,
m is 1,
n is a number ≥ 3 and ≤ 25 and
p is 1.

4. A radiation-sensitive mixture as claimed in claim 1 to 3, which contains 0.5 to 30 percent by weight, relative to the weight of the non-volatile components of the mixture, of compounds of the formula I.

5. A radiation-sensitive mixture as claimed in claim 1, wherein the 1,2-quinone diazide is a 1,2-naphthoquinone 2-diazide derivative which has an electronegative substituent in the 4- or 5-position.

6. A radiation-sensitive mixture as claimed in claim 5, wherein the electronegative substituent is an aryloxysulfonyl group.

7. A radiation-sensitive mixture as claimed in claim 1, wherein the binder is a polycondensation product or polymer having a phenolic hydroxyl group content in the range from 1 to 10 mmol/g of binder.

8. A radiation-sensitive recording material comprising a substrate and a radiation-sensitive layer applied thereto, which contains a mixture as claimed in claims 1 to 7.

9. A process for producing a negative recording material of a usually positive-working radiation-sensitive type which comprises a substrate and a radiation-sensitive layer applied thereto, by imagewise exposure, heat treatment, full exposure of the layer without an original and subsequent development with a developer, which comprises using a radiation-sensitive recording material as claimed in claim 8 and in which the heat treatment is carried out at temperatures between 80° and 150°C and for 10 seconds and 5 minutes.

## Revendications

1. Composition sensible aux radiations, qui contient comme consituants essentiels un liant polymère insoluble dans l'eau, soluble dans les solutions aqueuses alcalines, un 1,2-quinone-diazide et un composé diminuant par traitement thermique la solubilité dans le révélateur des domaines insolés, caractérisée en ce qu'elle contient en tant que composé diminuant la solubilité dans le révélateur au moins un uréthanne de formule générale I : 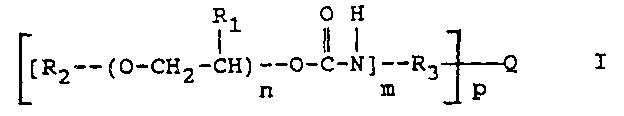 dans laquelle
R₁ représente un atome d'hydrogène ou un groupe méthyle,
R₂ représente un atome d'hydrogène, un groupe alkyle, un groupe aryle éventuellement substitué ou un groupe arylaminocarbonyle éventuellement substitué,
R₃ représente un groupe arylène ou arylène-alkylène éventuellement substitués,
Q représente un atome d'hydrogène, -CH₄₋ₚ, -CR₅R₆ où R₅ et R₆ peuvent être identiques ou différents et représentent un atome d'hydrogène, un groupe alkyle ou aryle, un groupe carbonyle, un atome d'oxygène ou de soufre ou un groupe sulfonyle,
m représente 1, 2 ou 3 et
n représente un nombre ≥ 1 et ≤ 50 et
p représente 1, 2 ou 3.

2. Composition selon la revendication 1, caractérisée en ce qu'elle contient au moins un composé correspondant à la formule générale I, dans laquelle :
R₁ représente un atome d'hydrogène ou un groupe méthyle,
R₂ représente un atome d'hydrogène, un groupe alkyle en C₁-C₂, phényle, naphtyle ou phénylaminocarbonyle, qui peuvent être substitués par des groupes alkyle,
R₃ représente un groupe phénylène, qui peut être substitué par des groupes alkyle,
Q représente un atome d'hydrogène ou un groupe méthylène,
m représente 1 ou 2,
n représente un nombre ≥ 3 et ≤ 25 et
p représente 1 ou 2.

3. Composition selon la revendication 1 ou 2, caractérisée en ce qu'elle contient au moins un composé correspondant à la formule générale I, dans laquelle :
R₁ représente un atome d'hydrogène,
R₂ représente un groupe phényle, phénylaminocarbonyle, qui peuvent être substitués par des groupes alkyle,
R₃ représente un groupe phénylène,
Q représente un atome d'hydrogène,
m représente 1,
n représente un nombre ≥ 3 et ≤ 25 et
p représente 1.

4. Composition sensible aux radiations selon l'une des revendications 1 à 3, caractérisée en ce qu'elle contient 0,5 à 30 % en poids de composés de formule générale I, par rapport à la masse des constituants non volatils de la composition.

5. Composition sensible aux radiations selon la revendication 1, caractérisée en ce que le 1, 2-quinone-diazide est un dérivé de 1,2-naphtoquinone-2-diazide qui posséde en position 4 ou 5 un substituant électronégatif.

6. Composition sensible aux radiations selon la revendication 5, caractérisée en ce que le substituant électronégatif est un groupe aryloxysulfonyle.

7. Composition sensible aux radiations selon la revendication 1, caractérisée en ce que le liant est un produit de polycondensation ou de polymérisation ayant une teneur en groupes hydroxy phénoliques dans la gamme de 1 à 10 mmol/g de liant.

8. Matériau de reproduction sensible aux radiations constitué d'une couche de support et d'une couche sensible aux radiations déposée sur cette dernière, qui contient une composition selon les revendications 1 à 7.

9. Procédé d'obtention en négatif d'un matériau d'enregistrement sensible aux radiations travaillant normalement en positif constitué d'une couche de support et d'une couche de composition sensible aux radiations déposée sur cette dernière, par insolation suivant une image, traitement thermique, insolation totale de la couche sans modèle suivie d'un développement avec un révélateur, caractérisé en ce que l'on utilise un matériau d'enregistrement sensible aux radiations selon la revendication 8 et en ce que l'on effectue le traitement thermique à des températures entre 80 et 150°C et pendant une durée comprise entre 10 secondes et 5 minutes.
